(19) Europäisches Patentamt
European Patent Office
Office européen des brevets

(11) **EP 4 318 941 A1**

(12) **EUROPEAN PATENT APPLICATION**

(43) Date of publication:
**07.02.2024 Bulletin 2024/06**

(21) Application number: **22188837.3**

(22) Date of filing: **04.08.2022**

(51) International Patent Classification (IPC):
$H03F\ 1/32^{(2006.01)}$     $H03F\ 3/24^{(2006.01)}$
$H03F\ 1/34^{(2006.01)}$

(52) Cooperative Patent Classification (CPC):
**H03F 1/3247; H03F 1/3258; H03F 3/24; H03F 3/34**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **University College Dublin**
**Belfield, Dublin 4 (IE)**

(72) Inventor: **The designation of the inventor has not yet been filed**

(74) Representative: **Purdylucey Intellectual Property**
**6-7 Harcourt Terrace**
**D02 FH73 Dublin 2 (IE)**

(54) **DIGITAL PREDISTORTION OF RF POWER AMPLIFIERS WITH DECOMPOSED VECTOR ROTATION-BASED RECURRENT NEURAL NETWORKS**

(57) Disclosed is a recurrent DVR model and a DVR based recurrent neural network for generating a non-linear output signal. The recurrent DVR model includes a magnitude recurrent filter for combining a magnitude of a current input signal with previous sequence information in a recurrent manner, to generate an intermediate output magnitude, a phase recurrent filter for combining a phase of a current input signal with previous sequence information in a recurrent manner, to generate an output phase, a DVR module for performing a DVR operation on the intermediate output magnitude to generate an output magnitude, and a multiplier for multiplying the output magnitude with cos and sine components of the output phase to generate cos and sine magnitude components respectively.

FIG.1

PRIOR ART

**Description**

<u>Field</u>

The present disclosure is directed towards RF Power Amplifiers in cellular wireless transmitters and more particularly to modelling digital predistortion of RF Power Amplifiers using neural networks. This disclosure can also be applied to other systems, such as nonlinear modelling of general transmitters in optical and satellite communications.

<u>Background</u>

With the advance of wireless standards, the fifth-generation (5G) communication systems are adopting higher carrier frequencies and wider signal bandwidth. While such an adaptation serves to high-capacity communication, modern radio frequency (RF) systems inevitably face significant challenges in maintaining high linearity while minimizing power consumption. Genuinely, power amplifiers (PAs) account for the majority of the power and cause foremost nonlinear distortion in RF systems. Owing to its allowing PAs to be operated at higher drive levels and compensating the nonlinear distortions, digital predistortion (DPD) is widely deployed in wireless base stations. The DPD is an approach that uses digital signal processing techniques to compensate for nonlinear distortion induced by RF PAs in wireless transmitters. DPD allows PAs to be operated at higher drive levels for higher power efficiency without losing linearity. The principle of DPD is that a nonlinear function is built up within the digital domain that is the inverse of the distortion function exhibited by the PA. In the literature, numerous DPD models have been proposed, such as memory polynomial (MP), generalized memory polynomial (GMP), envelope memory polynomial (EMP), dynamic deviation reduction (DDR), and so on. However, with constantly increasing signal bandwidth, the PA behaviour is now associated with more sophisticated nonlinear characteristics and memory effects. While endeavouring to model such complex systems, the existing models may fail to meet the required linearization performance. Relying on the impactful success of deep learning and its enormous potential for improvement, neural network learning emerges an appealing alternative in PA modelling.

Recently, many neural network-based DPD models have been proposed. When deploying a deep learning model, selecting a proper network structure to accurately model nonlinear dynamics of the PA becomes significantly challenging. In the existing works, DPD models are mainly built on traditional feed forward networks learning with memory samples. With longer memory effects, however, such models require a quite large number of memory samples, which intrinsically contributes to the complexity of the model. Recurrent models can involve an infinite number of past samples into the learning and therefore, potentially can lead to higher accuracy, but the conventional recurrent networks suffer from stability issues.

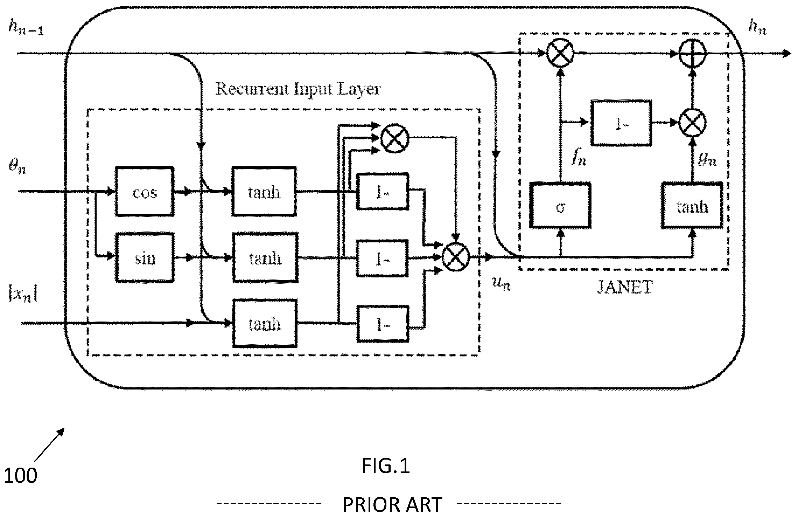

FIG.1 illustrates an existing phase gated recurrent neural network based DPD model 100, also referred to as a PG-JANET model 100. The PG-JANET model 100 is formed of a recurrent layer, and a Just Another Neural Network (JANET). The JANET network is a single gate simplified model of long short-term memory (LSTM) network.

As depicted in FIG.1, the recurrent operations in PG-JANET 100 can be described with the functions of forget gate $f_n$, inner cell $g_n$ and output $h_n$

$$\begin{cases} f_n = \sigma\left(W_f[x_n, h_{n-1}] + b_f\right) \\ g_n = \tanh\left(W_c[x_n, h_{n-1}] + b_c\right) \\ h_n = f_n \otimes h_{n-1} + (1 - f_n) \otimes g_n, \end{cases} \quad \ldots\ldots\ldots\ldots\ldots\ldots(1)$$

where $W_f$ and $W_c$ are the weights of the layers, and $b_f$ and $b_c$ are the bias while $[x_n, h_{n-1}]$ stands for concatenation between present input and previous output. Moreover, $\otimes$ and $\sigma$ represent element-wise multiplication and the sigmoid activation function respectively. The output function $h_n$ of PG-JANET 100 can be attributed to the PA behaviour described via a recurrent feedback structure that can cover long term memory effects. The processing of current input by associating it with the recurrent information is quite useful to capture the memory effects, rather than taking the input with multiple memory samples, which is the commonly adopted approach used in the PA modelling. However, despite the improvement made, to linearize ultra wideband PAs, e.g., with over 200 MHz modulated signals, a large number of coefficients are still required when linearizing wideband PAs. Further, the nonlinear process of the signals still relies on the conventional neural network approach, e.g., linear weighting with simple activation functions, which may not be effective in dealing with the complex nonlinear behaviour of the PA.

The DVR model is much more flexible, especially in modelling highly nonlinear systems and is different from the conventional polynomial based models, such as GMP. However, it is still in a feedforward structure, where the memory length that the model can cover depends on the number of memory samples are used in the input. This leads that, in a wideband system, the number of memory samples required can be very large, which, as a result significantly increases the model complexity.

Hence, in view of the above, there is a need for a DPD model that better models the complex nonlinearity and longer memory effects of the PA, and ensures a more practical design.

## Summary

According to the invention there is provided, as set out in the appended claims, a recurrent DVR model for generating a non-linear output signal, comprising:

a magnitude recurrent filter for combining a magnitude of a current input signal with previous sequence information in a recurrent manner using respective magnitude weighted matrices, to generate an intermediate output magnitude;
a phase recurrent filter for combining a phase of a current input signal with previous sequence information in a recurrent manner using respective phase weighted matrices, to generate an output phase;
a DVR module for performing a DVR operation on the intermediate output magnitude to generate an output magnitude; and
a multiplier for multiplying the output magnitude with cos and sine components of the output phase to generate cos and sine magnitude components respectively.

Various embodiments of the present invention present a novel decomposed vector rotation (DVR)-based recurrent neural network behavioural model for DPD of RF Pas in wideband scenarios. By representing memory terms of DVR with recurrent states and integrating the DVR processing with recurrent connections, a novel recurrent DVR scheme is proposed. To ensure stable operation and enhanced modelling accuracy, the recurrent DVR is integrated into the gated learning mechanism of modified Just Another NETwork (JANET). Experimental results confirm that the proposed DVR-JANET model provides much improved linearization performance and modelling accuracy with significantly reduced model complexity compared to the recent existing models. The novel recurrent DVR scheme adapts the flexible and powerful nonlinear modelling ability of DVR model to recurrent neural network learning. By integrating a powerful nonlinear processing, which is also well-tailored for PA and DPD modelling conditions, into the recurrent learning may further enhance the model capability. By building a novel recurrent DVR structure and integrating it into a gated recurrent network, the learning capability of the network is enhanced, with a smaller number of model coefficients.

In one embodiment the previous information includes a plurality of previous hidden elements stored by respective plurality of neurons, the intermediate output magnitude includes a plurality of intermediate output magnitude elements, the output phase includes a plurality of output phase elements, and the output magnitude includes a plurality of output magnitude elements, each computed by performing the DVR operation on respective intermediate output magnitude element.

In one embodiment each intermediate output magnitude element is computed first by weighing the plurality of hidden elements with respective plurality of hidden state weight co-efficients and weighing the magnitude of the current input signal with respective magnitude weight co-efficient, and combining the plurality of weighed hidden elements with the weighted magnitude.

In one embodiment each output phase element is computed first by weighing the plurality of hidden elements with respective plurality of hidden state weight co-efficients, and weighing the phase of the current input signal with respective phase weight co-efficient, and combining the plurality of weighed hidden elements with the weighted phase.

In one embodiment the DVR operation includes comparing an intermediate output magnitude element with a plurality of predefined thresholds, performing a non-linear operation on each comparison result, weighing output of each non-linear operation with respective model co-efficient, and summing a plurality of weighted outputs to generate corresponding output magnitude element.

In one embodiment a number of predefined thresholds is equal to a number of hyperplane partitions of the recurrent magnitude and phase filters, and wherein each predefined threshold defines a boundary of a partition.

In another embodiment there is provided a DVR based recurrent neural network (RNN) comprising: the recurrent DVR model as hereinbefore described integrated into a gated learning mechanism of the RNN.

In one embodiment the DVR based RNN further comprises:
the recurrent DVR model for:

generating an output magnitude and phase based on a current input, and previous sequence information, wherein the previous sequence information is a combination of previous in-phase and quadrature hidden outputs; and
generating cos and sine magnitude components based on the output magnitude and phase;
a forget gate for weighing the previous sequence information using a sigmoid activation function;

an in-phase inner cell for weighing between previous in-phase hidden output and cos magnitude component using a non-linear activation function;

a quadrature inner cell for weighing between previous quadrature hidden output and sin magnitude component using a non-linear activation function;

a first multiplier for generating a current in-phase hidden output based on outputs of the forget gate and the in-phase inner cell; and

a second multiplier for generating a current quadrature hidden output based on outputs of the forget gate and the quadrature inner cell.

In one embodiment the DVR based RNN further comprises fully-connected output layers for generating predicted in-phase and quadrature parts of a complex output signal based on the current in-phase and quadrature hidden outputs, and respective co-efficient matrices.

In on embodiment the previous in-phase hidden output includes a plurality of previous in-phase hidden elements, the previous quadrature hidden output includes a plurality of previous quadrature hidden elements, and wherein the intermediate output magnitude includes a plurality of intermediate output magnitude elements, and the output phase includes a plurality of output phase elements, and wherein the output magnitude includes a plurality of output magnitude elements, each computed by performing the DVR operation on respective intermediate output magnitude element.

## Brief Description of the Drawings

The invention will be more clearly understood from the following description of an embodiment thereof, given by way of example only, with reference to the accompanying drawings, in which:-

FIG.1 illustrates an existing phase gated recurrent neural network based DPD model;

FIGs.2A and 2B illustrate a recurrent DVR model, in accordance with an embodiment of the present invention;

FIG.3 illustrates a DVR-JANET model including the recurrent DVR model of FIGs. 2A and 2B, in accordance with an embodiment of the present invention;

FIG.4 summarizes the sequential learning of the DVR-JANET by illustrating the unfolded network with T timesteps, in accordance with an embodiment of the present invention;

FIG.5 demonstrates an experimental setup for the DVR, in accordance with an embodiment of the present invention;

FIG.6 is a graph illustrating NMSE(dB) of the compared models with different number of real valued model parameters for 100MHz OFDM test;

FIG.7 is a graph illustrating ACPR(dBc) of the compared models with different number of real valued model parameters for 100MHz OFDM test;

FIG. 8 is a graph illustrating power spectral density comparison between the models for 100MHz OFDM;

FIG. 9 is a graph illustrating AM/AM and AM/PM characteristics with and without DPD for 100MHz OFDM signal;

FIG.10 is a graph illustrating NMSE(dB) of the compared models with different number of real-valued model parameters for 200MHz OFDM test;

FIG.11 is a graph illustrating ACPR(dBc) of the compared models with different number of real valued model parameters for 200MHz OFDM test;

FIG.12 is a graph illustrating power spectral density comparison between the models for 200MHz OFDM test; and

FIG. 13 is a graph illustrating AM/AM and AM/PM characteristics with and without DPD for 100MHz OFDM signal.

## Detailed Description of the Drawings

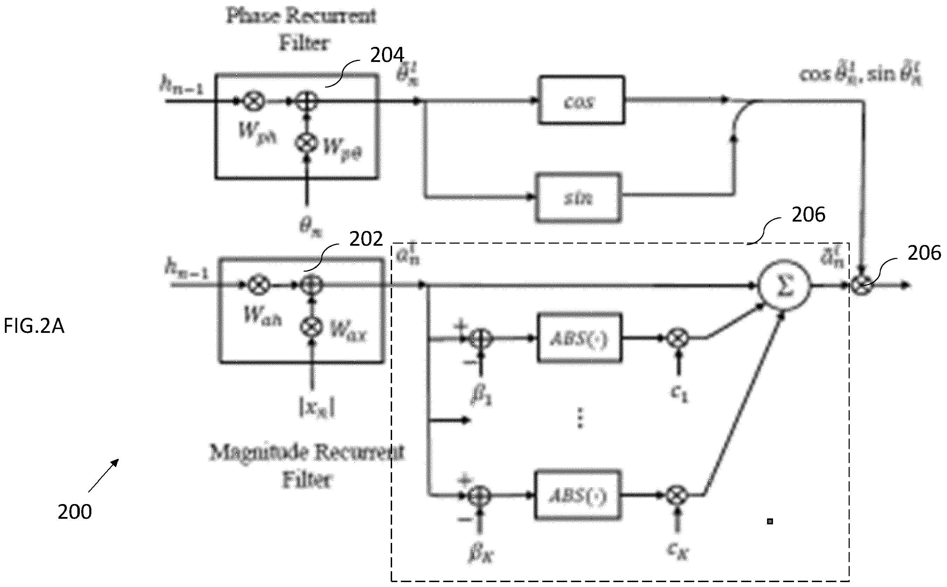

FIG.2A illustrates a recurrent DVR model 200, in accordance with an embodiment of the present invention.

The recurrent DVR model 200 includes a magnitude recurrent filter 202, a phase recurrent filter 204, and a DVR module 206. In an embodiment of the present invention, each of the magnitude recurrent filter 202 and the phase recurrent filter 204 is a recurrent neural network (RNN) that perform recurrent operations on a magnitude $|x_n|$ and a phase $\theta_n$ of an input signal $x_n$ at current time instant 'n' respectively. The input signal $x_n$ may be a baseband data signal of a given frequency, which may be decomposed into magnitude $|x_n|$ and phase $\theta_n$.

The basic operation of the magnitude recurrent filter 202 may be expressed by the following equation:

$$a_n = W_{ax} \otimes |x_n| + W_{ah} \otimes h_{n-1} \qquad \ldots\ldots\ldots\ldots\ldots(2)$$

where $W_{ax}$ and $W_{ah}$ are magnitude weight matrices, $|x_n|$ and $a_n$ denote input and output magnitude of the magnitude recurrent filter 202 at time instant n. Further, $h_{n-1}$ represents the previous hidden information of the magnitude recurrent filter 202 at previous time instant n - 1. Essentially, the magnitude recurrent filter 202 generates the output magnitude based on current input, and past information.

The basic operation of the phase recurrent filter 204 may be expressed by the following:

$$\tilde{\theta}_n = W_{p\theta} \otimes \theta_n + W_{ph} \otimes h_{n-1} \qquad \ldots\ldots\ldots\ldots(3)$$

where $W_{p\theta}$ and $W_{ph}$ are phase weight matrices, $\theta_n$ and $\tilde{\theta}_n$ denote input and output phases of the magnitude recurrent filter 204 at time instant n. Essentially, the magnitude recurrent filter 202 generates the output phase based on current phase, and past information.

The main motivation behind the magnitude and phase recurrent filters 202 and 204 is to combine the input signal $x_n$ with the previous sequence information from the previous recurrent output $h_{n-1}$, by weighing them with the related coefficient matrices. The recurrent DVR model 200 stores the input $x_n$ at a given instant n, with the hidden information within the neurons of corresponding RNN. This enables to associate the magnitude and the phase of complex-valued input PA data with a long range of past information in the system.

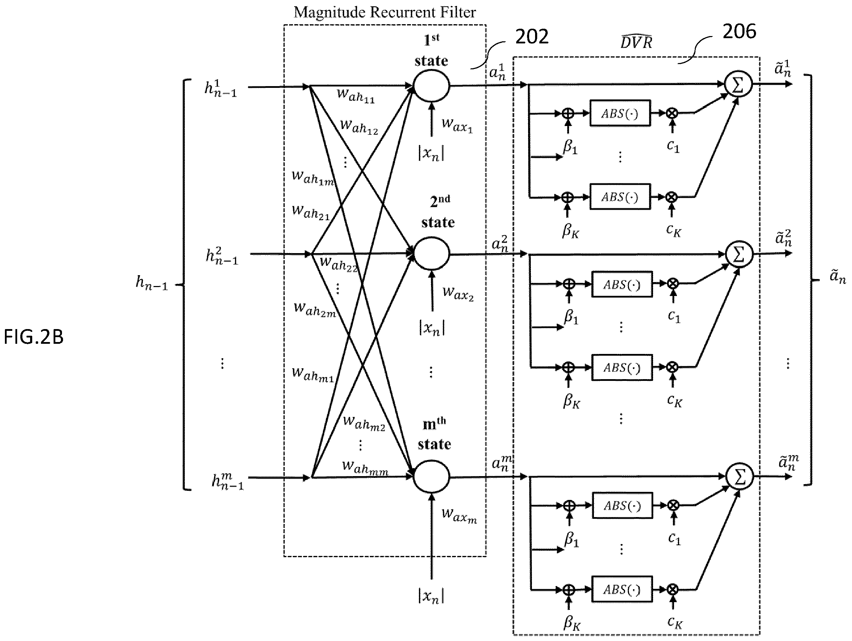

Referring to FIGs. 2A and 2B, the magnitude recurrent filter 202 generates m magnitude elements $a_n^1, a_n^2 \ldots\ldots a_n^m$ of magnitude $a_n$ based on respective m elements $h_{n-1}^1, h_{n-1}^2 \ldots\ldots h_{n-1}^m$ of $h_{n-1}$, where $l = 1,2,3 \ldots . m$. The m elements $h_{n-1}^1, h_{n-1}^2 \ldots\ldots h_{n-1}^m$ represent the previous hidden information carried by m neurons at previous time instant n - 1. Thus, the m magnitude elements $a_n^1, a_n^2 \ldots\ldots a_n^m$ represent the magnitude information carried by m neurons.

Each magnitude element $a_n^l$ may be estimated using the following equation:

$$a_n^l = \sum_{i=1}^{m} w_{ah_{li}} h_{n-1}^i + w_{ax_l} |x_n|, \qquad \ldots\ldots\ldots\ldots\ldots(4)$$

where $w_{ah_{li}}$ and $w_{ax_l}$ are the $l^{th}$ coefficients in the weight matrices $W_{ah}$ and $W_{ax}$ respectively.

The input to the DVR module 206 constitutes m magnitude elements $a_n^1, a_n^2 \ldots\ldots a_n^m$ from the magnitude recurrent filter 202. The DVR module 206 compares each magnitude element $a_n^l$ with multiple predefined thresholds $\beta_k$ (k = 1,2 ... K), and then performs a non-linear operation on each comparison result, via the "absolute" value (ABS (.)) operation. The DVR module 206 finally multiplies output of each absolute operation with corresponding model coefficient, and sums up all the multiplied values, to generate corresponding output magnitude element $\tilde{a}_n^l$.

The combined operation of the magnitude recurrent filter 202 and the DVR module 206 forms a non-linear basis function, and is represented by the following:

$$\tilde{a}_n^l = \sum_{k=1}^{K} c_k \left| \sum_{i=1}^{m} w_{ah_{li}} h_{n-1}^i + w_{ax_l} |x_n| - \beta_k \right| \qquad \ldots\ldots\ldots\ldots(5)$$

$a_n^l$ where,

$\tilde{a}_n^l = l^{th}$ element of output magnitude $\tilde{a}_n$

$c_k$ = model co-efficient

$\beta_k$ = threshold

$l$ = 1, 2, ... , m

In an embodiment of the present invention, the output magnitude $\tilde{a}_n$ is a set including m elements $\tilde{a}_n^l, \tilde{a}_n^2 \ldots \ldots \tilde{a}_n^m$. It is to be noted that each element $\tilde{a}_n^l$ of output magnitude $\tilde{a}_n$ defines a different hyperplane partition as each hidden neuron stores the past information with a different weight. Hence, the previous sequence information differs for each neuron. $| \cdot |$ stands for the absolute value operation whereas $K$ is the number of the partitions, and $\beta_k$ becomes the threshold which decides the boundary of that partition. $M$ represents the memory length. Though, all the magnitude elements $a_n^l$ are compared with the same threshold $\beta_k$ and the comparison results, are weighted by the same model coefficient $c_k$, each magnitude element $a_n^l$ of the magnitude recurrent filter may point out a different DVR structure.

Although not shown, the phase recurrent filter 204 uses the equation (3) to generate m phase elements $\left( \tilde{\theta}_n^1 \ldots . . \tilde{\theta}_n^m \right)$ of output phase $\tilde{\theta}_n$ based on respective m elements $h_{n-1}^1, h_{n-1}^2 \ldots \ldots . h_{n-1}^m$ of $h_{n-1}$. Thus, at time instant 'n', each neuron stores a phase element of the output phase.

The recurrent DVR model 200 further includes a cos module to generate cos component $cos\tilde{\theta}_n^l$ of phase $\tilde{\theta}_n$, a sine module to generate a sin component $sin\tilde{\theta}_n^l$ of phase $\tilde{\theta}_n$, and a multiplier 206 for generating cos magnitude and sine magnitude components $\tilde{a}_n^l sin\tilde{\theta}_n^l$ and $\tilde{a}_n^l cos\tilde{\theta}_n^l$.

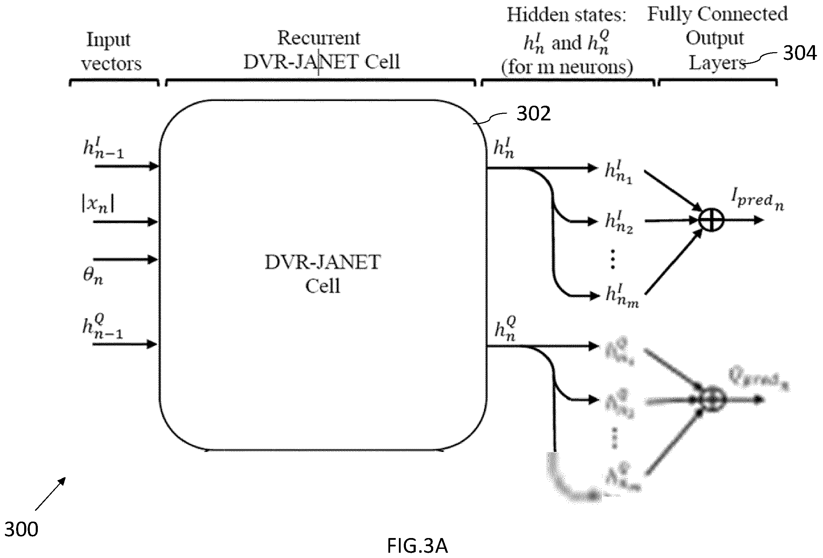

FIG.3A illustrates a DVR-JANET model 300 for DPD modelling of RF PAs, in accordance with an embodiment of the present invention. The DVR-JANET model 300 is formed by integrating the recurrent DVR model 200 into the gated learning mechanism of a modified Just Another NETwork (JANET).

The DVR-JANET model 300 includes a recurrent DVR-JANET cell 302 that receives a plurality of input vectors, and generates in-phase and quadrature hidden states $h_n^I$ and $h_n^Q$ for m neurons at time instant n. The DVR-JANET model 300 further includes fully connected output layers 304 that receives the in-phase and quadrature hidden states for m neurons at time instant n and outputs predicted in-phase and quadrature outputs $I_{pred_n}$ and $Q_{pred_n}$ at time instant n. The plurality of input vectors includes previous and quadrature in-phase hidden states $h_{n-1}^I$ and $h_{n-1}^Q$, and magnitude $|x_n|$ and phase $\theta_n$ of an input signal $x_n$ at current time instant 'n'.

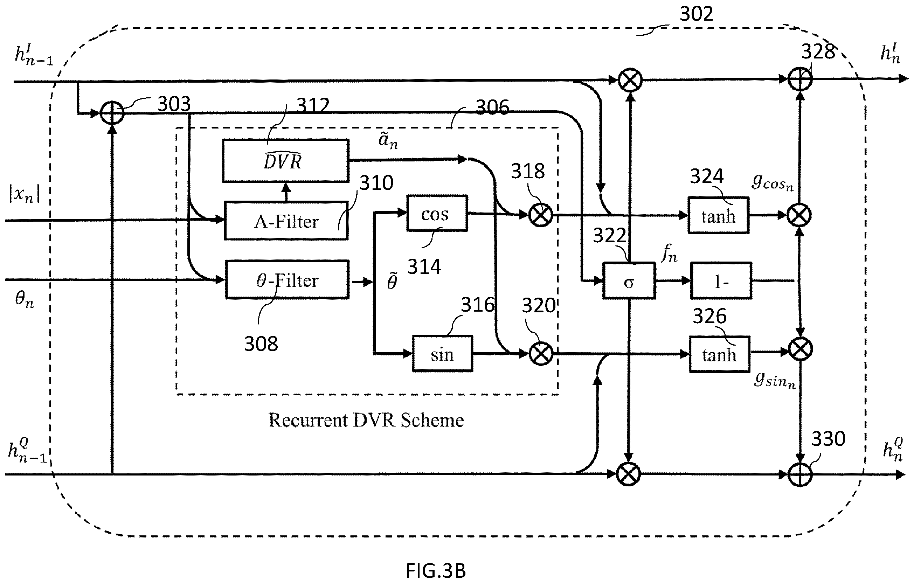

Referring to FIG.3B, the recurrent DVR-JANET cell 302 includes a recurrent DVR model 306 (similar to the recurrent DVR model 200). The recurrent DVR model 306 includes a phase recurrent filter 308 (similar to the phase recurrent filter 204), a magnitude recurrent filter 310 (similar to the magnitude recurrent filter 202), cos and sin modules 314 and 316, and first and second multipliers 318 and 320.

The operation of the DVR-JANET model 300 can be described by the following equations:

$$\begin{cases} \tilde{a}_n = \widehat{DVR}\left( W_{ax} \otimes |x_n| + W_{ah} \otimes (h^I_{n-1} \oplus h^Q_{n-1}) \right) & \text{.............. (6)} \\[2mm] \tilde{\theta}_n = W_{p\theta} \otimes \theta_n + W_{ph} \otimes (h^I_{n-1} \oplus h^Q_{n-1}) & \text{.............. (7)} \\[2mm] f_n = \sigma\left( W_f[(h^I_{n-1} \oplus h^Q_{n-1})] + b_f \right) & \text{...........................(8)} \\[2mm] g_{cos_n} = \tanh\left( W_{c_{cos}}[h^I_{n-1}, \tilde{a}_n \otimes cos\tilde{\theta}_n] + b_{g_{cos}} \right) & \text{.................(9)} \\[2mm] g_{sin_n} = \tanh\left( W_{c_{sin}}[h^Q_{n-1}, \tilde{a}_n \otimes sin\tilde{\theta}_n] + b_{g_{sin}} \right) & \text{.................(10)} \\[2mm] h^I_n = f_n \otimes h^I_{n-1} + (1 - f_n) \otimes g_{cos_n} & \text{.................(11)} \\[2mm] h^Q_n = f_n \otimes h^Q_{n-1} + (1 - f_n) \otimes g_{sin_n} & \text{...........................(12)} \\[2mm] I_{pred_n} = W_{o_1} h^I_n & \text{..............................(13)} \\[2mm] Q_{pred_n} = W_{o_2} h^Q_n & \text{..............................(14)} \end{cases}$$

It is to be noted that the DVR-JANET cell 302 has two hidden states $h^I_{n-1}$ and $h^Q_{n-1}$ carrying different past feedback data. In an embodiment of the present invention, the two hidden states may be combined with the element-wise addition operator 303, as the consequent past sequence information for the magnitude and the phase recurrent filters 310 and 308. With the history information, the magnitude and the phase recurrent filters 310 and 308 perform a linear mapping on the input sequences $|x_n|$ and phase $\theta_n$.

In operation, the magnitude recurrent filter 310 and the DVR module 312 generates the output magnitude $\tilde{a}_n$ using equation (6) based on the magnitude $|x_n|$ and previous in-phase and quadrature hidden states $h^I_{n-1}$ and $h^Q_{n-1}$. It is to be noted that the output magnitude $\tilde{a}_n$ includes m magnitude elements stored by m neurons, estimated based on corresponding m elements of previous in-phase and quadrature hidden states $h^I_{n-1}$ and $h^Q_{n-1}$. It is to be noted that the output magnitude $\tilde{a}_n$ is calculated in a manner as described in the equation (5), except that the previous hidden state is a concatenation of previous in-phase and quadrature hidden states $h^I_{n-1}$ and $h^Q_{n-1}$. The phase recurrent filter 308 generates the output phase $\tilde{\theta}_n$ in a manner as described before, except that the previous hidden state is a concatenation of previous in-phase and quadrature hidden states $h^I_{n-1}$ and $h^Q_{n-1}$. It is to be noted that the output phase $\tilde{\theta}_n$ includes m phase elements stored by m neurons. The first multiplier 318 multiplies the output magnitude $\tilde{a}_n$ with cos of the output phase $\tilde{\theta}_n$ to generate a cos magnitude component $\tilde{a}_n cos\tilde{\theta}_n$ and the second multiplier 320 multiples the output magnitude $\tilde{a}_n$ with sin of the output phase $\tilde{\theta}_n$ to generate a sin magnitude component $\tilde{a}_n sin\tilde{\theta}_n$. Thus, the recurrent DVR model 306 generates the cos magnitude component $\tilde{a}_n cos\tilde{\theta}_n$ and the sin magnitude component $\tilde{a}_n sin\tilde{\theta}_n$ as two outputs.

The DVR-JANET cell 302 further includes a forget gate 322 that is an RNN to process the hidden information, i.e. the output of the operator 303 to implement a forget gate function $f_n$, where $W_f$ is the weight matrix of the forget gate 322, and $b_f$ is bias of the forget gate 322. Like the recurrent filters, the forget gate function $f_n$ conducts its operation with the combination of previous in-phase and quadrature hidden states. If the usual behaviour of PAs is considered, it can be seen that the output signal is mostly dominated by the instantaneous input sample. Building on that, the current input can be released from an existing forget operation and, therefore, only the hidden information is processed through the forget gate 322, which lowers the overall complexity.

The DVR-JANET cell 302 further includes first and second inner cells 324 and 326, for implementing in-phase and quadrature inner cell functions $g_{cos_n}$ and $g_{sin_n}$ instead of $g_n$ (as illustrated in FIG. 1), and separately encoding the cos and sin magnitude components. With the additional inner cell, two separate $W_{c_{cos}}$ and $W_{c_{sin}}$ are defined as the weights of the layers and $b_{g_{cos}}$ and $b_{g_{sin}}$ are biases of the in-phase and quadrature inner cells 324 and 326. The in-phase inner cell function $g_{cos_n}$ represents weighing between previous in-phase hidden state, and cos magnitude component using a non-linear activation function tanh. The quadrature inner cell function $g_{sin_n}$ represents weighing between previous quadrature hidden state, and sin magnitude component using the non-linear activation function tanh. The recurrent DVR model 306 generates cosine and sine components $\tilde{a}_n cos\tilde{\theta}_n$ and $\tilde{a}_n sin\tilde{\theta}_n$. Instead of concatenating these through one inner cell, encoding the cosine and sine components of the phase restoration in separate two inner memory cells 324 and 326 would provide the network 300 a better learning capability for each information.

The in-phase adder 328 generates present in-phase hidden state $h_n^I$ based on the forget gate function $f_n$ and in-phase inner cell function $g_{cos_n}$ using equation (11). Similarly, the quadrature adder generates present quadrature hidden state $h_n^Q$ based on the forget gate function $f_n$ and quadrature inner cell function $g_{sin_n}$ using equation (12). Thus, the present in-phase and quadrature hidden states $h_n^I$ and $h_n^Q$ are estimated using their own previous recurrent states $h_{n-1}^I$ and $h_{n-1}^Q$ respectively.

Thus, by using the forget gate 322 and two inner memory cells 324 and 326, the network 302 generates two recurrent states $h_n^I$ and $h_n^Q$. Both the recurrent states $h_n^I$ and $h_n^Q$ are calculated in a manner similar to the calculation of the output function $h_n$ (see, equation (1)) of the PG-JANET 100 by using $g_{cos_n}$ and $g_{sin_n}$ separately.

The present in-phase and quadrature hidden states $h_n^I$ and $h_n^Q$ are fed to the fully connected output layers 304 whose coefficient matrices are $W_{o1}$ and $W_{o2}$ to generate the predicted in-phase ($I_{pred_n}$) and the quadrature ($Q_{pred_n}$) parts of the complex-valued pre-distorted signal, i.e., the output of the complete model 300.

Training of the DVR-JANET 300

Considering the acquired behavioral model of the PA, the same model architecture 300 can be exactly used for DPD by swapping the input and output of the PA. Entire procedure consists of three stages, as previously described in the prior work and also summarized in Algorithm 1.

| **Algorithm 1** DVR-JANET Training Algorithm |
|---|
| **Pretraining Stage:** ILC Test |
| **Input:** x **and** y |
| **Output:** x **and** $u_{ilc}$ |
| 1: Minimize the error between x and y iteratively |
| 2: Obtain the dataset of the target DPD for the training |
| **Learning Stage:** Neural Network Training |
| **Input:** x **and** $u_{ilc}$ |
| **Output: Model Coefficients** |
| 3: Train the network with x and $u_{ilc}$ |
| 4: Determine the model coefficients |
| **Adaptive Stage:** DLA-based Fine Tuning |
| **Input:The weights of DVR-JANET cell,** $\hat{x}$ **and** $\hat{y}$ |
| **Output: Updated Model Coefficients** |
| 5: Use the coefficients of the DVR-JANET cell directly |
| 6: Tune the parameters of the fully connected linear layers in a DLA scheme for the final prediction |

When deploying a neural network-based DPD, a training dataset is required. To teach the proposed neural network 300 to identify the target DPD, this dataset is obtained from an existing ILC method. The ILC unit minimizes the error between, the input *x* and the output y of the PA iteratively updating its output to the controlled system. Therefore, it determines the ideal input $u_{ilc}$ of the PA for the minimum error achieved and provides the training dataset consisting of *x* and $u_{ilc}$ for the DVR-JANET learning.

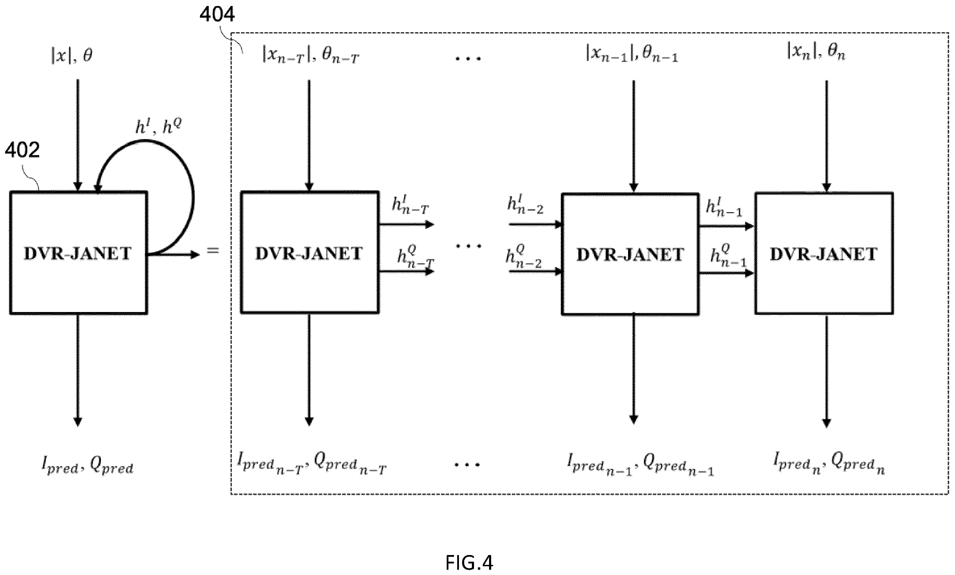

After the preparation stage, next step attempts to identify the weights of the DPD model. FIG.4 summarizes the sequential learning of the DVR-JANET by illustrating the unfolded network with T timesteps. The folded DVR-JANET 402 simply shows the input and the output vectors together with the recurrent states of the network. DVR-JANET block processes the input consisting of the magnitude vector $|x|$, and the phase vector $\theta$ by directly feeding the previous hidden information $h^I$ and $h^Q$ back to the model, and then predicts the output y = [$I_{pred}$, $Q_{pred}$]. The Recurrent DVR-JANET 300 decides the model parameters over multiple steps. This learning may be simplified by unfolding its representation along the input sequence, which is illustrated through the DVR-JANET blocks in 404. This is a useful conceptual visualization to clarify how the network processes

the input samples during the forward pass. At time instant n, for example, the model takes the new input $|x_n|$ and $\theta_n$ and

uses the hidden state information $h^I_{n-1}$ and $h^Q_{n-1}$ in the memory cells, then it generates the model output based on the equations (6)-(14). After one complete pass of the input sequence, predicted multiple time steps of the output vector are predicted. It should be especially noted that DVR-JANET network 402 does not change between the time steps. It is always the same block using the same set of parameters for each time step until the next update of model coefficients. Lastly, an adaptive stage is added to the training called direct learning (DLA)-based fine tuning. The ultimate goal of this phase is to update the DPD occasionally in case any variation in the input-output, $\hat{x}$-$\hat{y}$, characteristics happens. During this stage, the coefficients of the recurrent unit would be reused and retained, while the weights of the final linear layers are fine-tuned before the final model prediction. Considering the fine-tuning is a pure linear system identification problem, it results in a very low complexity.

## EXPERIMENTAL VALIDATION

To validate the linearization performance of the proposed model, different experimental tests were conducted and the results are presented herein.

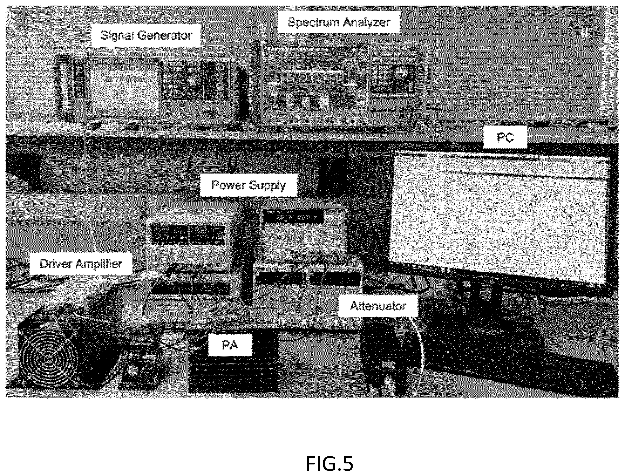

FIG.5 demonstrates the experimental setup including a test computer (PC) running MATLAB and PyTorch software, a Vector Signal Generator (SMW200A) by Rohde & Schwarz controlled via the test computer, a linear driver amplifier, an in-house designed Doherty power amplifier [30], a -30 dB RF attenuator and a Spectrum Analyzer (FSW50) from Rohde & Schwarz. During the experiment, the input signal is generated in MATLAB running on the PC and then sent to the Vector Signal Generator, which forms the baseband signal and upconverts it to the carrier frequency of 3.2 GHz. After passing the linear driver amplifier, the up-converted signal becomes the input of the PA. The output is attenuated before coming to Spectrum Analyzer, which finally down-converts and digitizes the output signal to be saved in the PC.

Throughout the experiment, the DVR-JANET model 300 is compared with the PG-JANET 100, and DVR and GMP models. As two different wideband scenarios, the measurements are performed with test signals of 100MHz and 200MHz orthogonal frequency-division multiplexing (OFDM) with 7.7dB PAPR (peak to average power ratio). The average output power of the PA is 35.7dBm. After ILC test, 160,000 I/Q samples are recorded with the sampling frequencies of 400MHz and 800MHz respectively for the training of the proposed DVR-JANET 300 and PG-JANET 100, both of which has 1 recurrent layer, and are trained with the batch size of 40 during 500 epochs and tested with different number of hidden neurons. To update of network weights, adaptive moment estimation (ADAM) optimizer is adopted and to enhance the modelling accuracy, a decaying learning rate method is followed, which decreases the learning rate by 10 after learning curve saturates.

For DVR and GMP, same number of I/Q samples are used for the model extraction and their configurations also differs in various tests. As the performance comparison metrics, normalized mean square error (NMSE) and adjacent channel power ratio (ACPR) are presented. To compare the model complexity, the number of real-valued parameters are considered as the main criteria, which suggests that a complex-valued parameter of DVR and GMP is counted as two real valued free parameters during the comparison.

## EXPERIMENTAL RESULTS

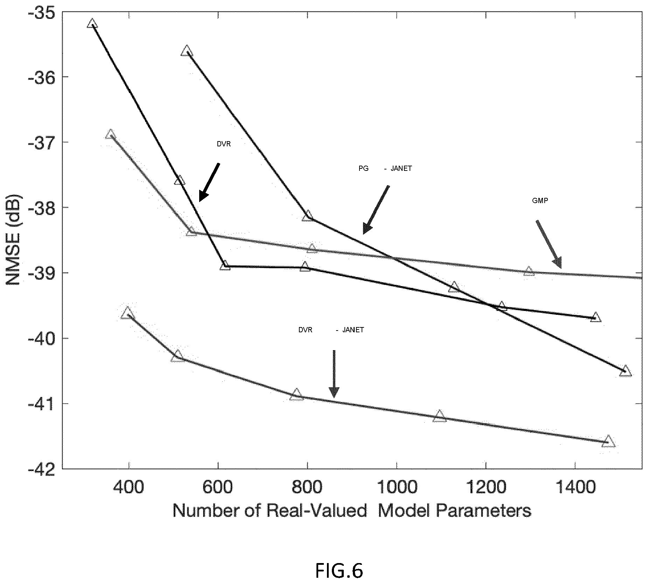

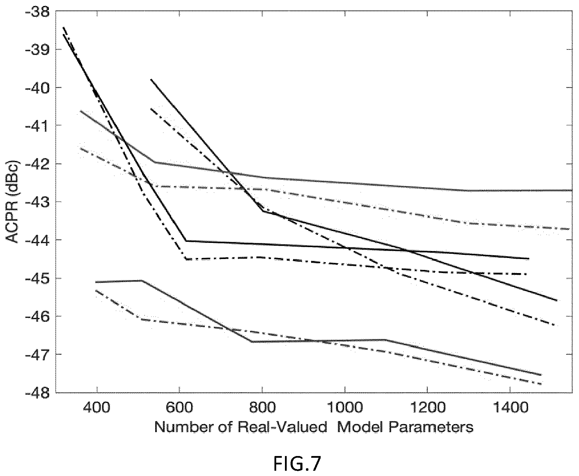

*1) Test Results of 100 MHz OFDM Signal:* The first wideband experimental validation is performed with 5-carrier test signal of 100 MHz. This measurement aims to carry out an extensive search to understand how the models perform with different number of model parameters and to present a broad comparison by taking various configurations of them into consideration eventually. In this test, the number of hidden states is swept from 8 to 14 for DVR-JANET 300 and PG-JANET 100 respectively. On the other hand, DVR and GMP were specifically configured so that they can attain their best performance for each evaluation point. FIGs. 6 and 7 depict how NMSE and ACPR of the models change by increasing the number of model parameters, which points out that each model comes with an improvement in modelling accuracy in case they have a larger set of model coefficients. Besides, note that any of them can be adopted with their own specific configuration for a linearization task considering the indicators of the model performance in FIGs. 6 and 7. Nevertheless, among the compared models, GMP becomes the most suffering one from the problem of the restricted capability despite of increasing model parameters. Considering its quickly saturated performance, it can be deduced that there is almost no room for further improvement. DVR and PG-JANET, however, allow more flexibility to accomplish better modelling performance with higher number of model coefficients. Here, it should be remarked that PG-JANET 100 still can provide much less NMSE and ACPR than the best result of DVR after reaching a particular complexity level.

Ultimately, the DVR-JANET 300 appears to have a great advantage over the compared models in each comparison metric. It not only results in the most successful linearization all the time, but also it distinctively provides a much better performance even with a relatively small number of model parameters. For further discussion, to closely investigate the modelling capability of the models in a similar complexity, the number of model parameters may be limited within a particular range and evaluate the model performance. This enables a fair comparison between the models under a complexity budget. For this purpose, a comparison may be probed when each model has approximately 500 real-valued parameters.

The test results can be found in below Table I:

TABLE I PERFORMANCE COMPARISON OF THE MODELS FOR 100MHZ OFDM SIGNAL

| Model Type | NMSE (dB) | ACPR (dBc) (lower/upper) | Number of Parameters (real-valued) |
|---|---|---|---|
| Without DPD | -26.43 | -36.23/-29.96 | N/A |
| GMP | -38.25 | -42.75/-42.08 | 540 |
| DVR | -37.81 | -43.48/-42.56 | 538 |
| PG-JANET | -35.60 | -40.56/-39.80 | 530 |
| DVR-JANET | -40.27 | -46.10/-45.10 | 509 |

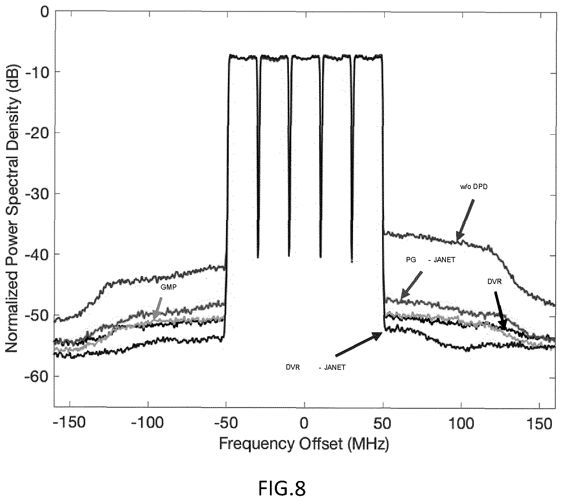

Table I demonstrates the NMSE, ACPR and the total number of the model parameters. In this specific case, the PG-JANET 100 and DVR-JANET 300 are tested with 8 hidden states and $K$=3 for DVR-JANET. GMP model is used with only lagging terms with memory depth of 5, the polynomial order of 5 and cross term length of 8. Finally DVR model has 12 partitions with memory length of 5 including linear terms, 1st-order basis, 2nd-order type-1 terms, 2nd-order type-2, 2nd-order type-3 terms and DDR-1 terms. Table I and FIG.8 confirms that the proposed DVR-JANET 300 exhibits a distinguished competence, when a less complex model is strictly needed. It explicitly brings about a better performance, which is at least 2dB better in both NMSE and ACPR when compared with DVR and GMP.

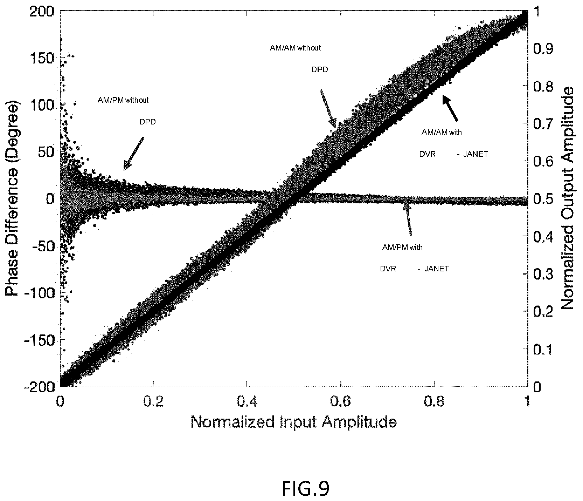

In case when PG-JANET 100 and DVR-JANET 300 are compared, almost 5dB difference in both of the performance metrics can be observed. Even though PG-JANET 100 is a quite powerful model that can attain much better results than conventional DPDs, it may no longer have the capability to model the PA effectively if the sources are limited. The AM/AM and AM/PM characteristics of the PA can be seen in FIG.9 showing the behaviour both without DPD and with DPD based on DVR-JANET 300.

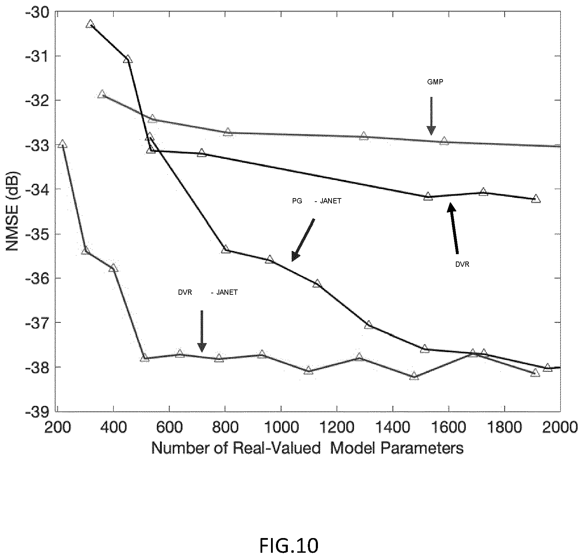

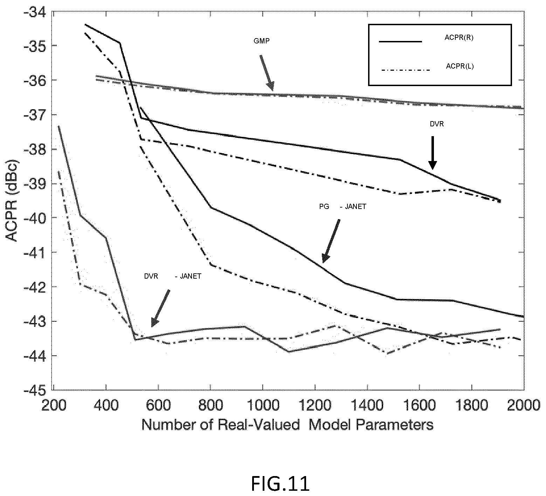

*2) Test Results of 200 MHz OFDM Signal:* To validate the performance of the proposed model in an even wider bandwidth, the second test is conducted with 10-carrier 200 MHz OFDM signal. This measurement basically examines how the model performs when the linearization problem becomes more challenging due to the higher distortion induced by the PA. Like the first measurement, this experimental work intends to present a comprehensive comparison between the models under several configurations of them, which leads to different number of model parameters. In this regard, FIGs. 10 and 11 provide not only the results of various measurements in terms of NMSE and ACPR and but also an important insight regarding their modeling capabilities. To obtain these results, the number of hidden states of DVR-JANET and PG-JANET are swept from 6 to 17 and from 8 to 18, respectively. Besides, DVR and GMP are tuned to their best performance again as discussed previously. In the presence of stronger distortion, the conventional models demonstrate a severe lack of an effective DPD modelling, which can be observed from FIGs. 10 and 11. Apparently, the higher model complexity does not allow them to improve their modelling accuracy. On the other hand, PG-JANET 100 and DVR-JANET 300 obviously can reach a particular linearization performance, which emphasizes the importance of a flexible and effective neural network modelling. From both FIGs. 10 and 11, it can be concluded that the best possible performance of DVR-JANET 300 and PG-JANET 100 converge towards nearly the same level.

However, DVR-JANET 300 obviously arrives at the targeted performance with a much less complex model configuration, which has nearly one-third of the PG-JANET 100 model parameters. Based on this, it can be concluded that DVR-JANET 300 shows a great improvement on the learning ability of PG-JANET 100. Similarly, the performance of the compared models are presented in Table II when they have nearly 500 real-valued parameters.

TABLE II PERFORMANCE COMPARISON OF THE MODELS FOR 200MHz OFDM SIGNAL

| Model Type | NMSE (dB) | ACPR (dBc) (lower/upper) | Number of Parameters (real-valued) |
|---|---|---|---|
| Without DPD | -24.82 | -31.94/-28.06 | N/A |
| GMP | -32.43 | -36.19/-35.73 | 540 |
| DVR | -33.14 | -37.72/-36.62 | 534 |
| PG-JANET | -32.83 | -37.92/-36.78 | 530 |
| DVR-JANET | -37.82 | -43.40/-43.55 | 511 |

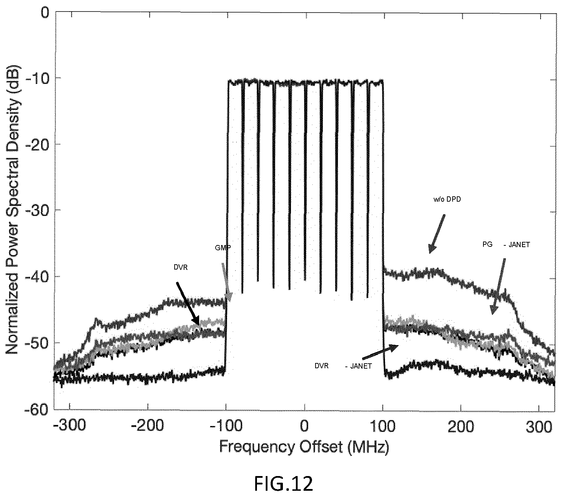

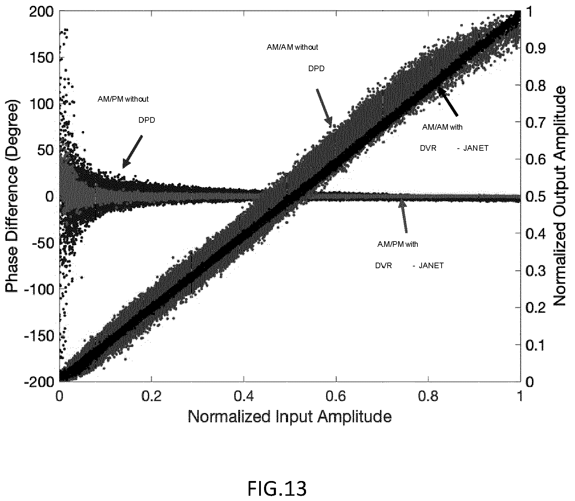

The output spectrum, AM/AM and AM/PM plots are also depicted in FIGs.12 and 13. For this test, PG-JANET 100 and DVR-JANET 300 are configured with 8 hidden states and $K$=5 for DVR-JANET. While GMP was tested with the same configuration employed in 100 MHz band, the DVR model configuration changed to the partition number of 10 and the memory length of 10, including linear terms, 1st-order basis, 2nd-order type-1 terms, 2nd-order type2.

In this case, both Table II and FIG.12 indicate that only the DVR-JANET 300 can provide a competent compensation of the nonlinear distortion within this particular complexity range while the others result in a poor linearization performance. That also verifies the absolute superiority of DVR-JANET over the compared models.

It will be appreciated that the invention hereinbefore described can be applied in various settings, such as also be applied to other systems, such as nonlinear modelling of general transmitters in optical and satellite communications.

In the specification the terms "comprise, comprises, comprised and comprising" or any variation thereof and the terms include, includes, included and including" or any variation thereof are considered to be totally interchangeable, and they should all be afforded the widest possible interpretation and vice versa.

The invention is not limited to the embodiments hereinbefore described but may be varied in both construction and detail.

**Claims**

1. A recurrent DVR model for generating a non-linear output signal, comprising:

   a magnitude recurrent filter for combining a magnitude of a current input signal with previous sequence information in a recurrent manner using respective magnitude weighted matrices, to generate an intermediate output magnitude;
   a phase recurrent filter for combining a phase of a current input signal with previous sequence information in a recurrent manner using respective phase weighted matrices, to generate an output phase;
   a DVR module for performing a DVR operation on the intermediate output magnitude to generate an output magnitude; and
   a multiplier for multiplying the output magnitude with cos and sine components of the output phase to generate cos and sine magnitude components respectively.

2. The recurrent DVR model as claimed in claim 1, wherein the previous information includes a plurality of previous hidden elements stored by respective plurality of neurons, the intermediate output magnitude includes a plurality of intermediate output magnitude elements, the output phase includes a plurality of output phase elements, and the output magnitude includes a plurality of output magnitude elements, each computed by performing the DVR operation on respective intermediate output magnitude element.

3. The recurrent DVR model as claimed in claim 2, wherein each intermediate output magnitude element is computed first by weighing the plurality of hidden elements with respective plurality of hidden state weight co-efficients and weighing the magnitude of the current input signal with respective magnitude weight co-efficient, and combining the plurality of weighed hidden elements with the weighted magnitude.

4. The recurrent DVR model as claimed in claim 2, wherein each output phase element is computed first by weighing the plurality of hidden elements with respective plurality of hidden state weight co-efficients, and weighing the phase of the current input signal with respective phase weight co-efficient, and combining the plurality of weighed hidden elements with the weighted phase.

5. The recurrent DVR model as claimed in any preceding claim, wherein the DVR operation includes comparing an intermediate output magnitude element with a plurality of predefined thresholds, performing a non-linear operation on each comparison result, weighing output of each non-linear operation with respective model co-efficient, and summing a plurality of weighted outputs to generate corresponding output magnitude element.

6. The recurrent DVR model as claimed in claim 5, wherein a number of predefined thresholds is equal to a number of hyperplane partitions of the recurrent magnitude and phase filters, and wherein each predefined threshold defines a boundary of a partition.

7. A DVR based recurrent neural network (RNN) comprising: the recurrent DVR model as claimed in claims 1-6 integrated into a gated learning mechanism of the RNN.

8. The DVR based RNN as claimed in claim 7, further comprising:

   the recurrent DVR model for:

      generating an output magnitude and phase based on a current input, and previous sequence information, wherein the previous sequence information is a combination of previous in-phase and quadrature hidden outputs; and
      generating cos and sine magnitude components based on the output magnitude and phase;

   a forget gate for weighing the previous sequence information using a sigmoid activation function;
   an in-phase inner cell for weighing between previous in-phase hidden output and cos magnitude component using a non-linear activation function;
   a quadrature inner cell for weighing between previous quadrature hidden output and sin magnitude component using a non-linear activation function;
   a first multiplier for generating a current in-phase hidden output based on outputs of the forget gate and the in-phase inner cell; and
   a second multiplier for generating a current quadrature hidden output based on outputs of the forget gate and the quadrature inner cell.

9. The DVR based RNN as claimed in claim 8 further comprising fully-connected output layers for generating predicted in-phase and quadrature parts of a complex output signal based on the current in-phase and quadrature hidden outputs, and respective co-efficient matrices.

10. The DVR based RNN as claimed in claim 8, wherein the previous in-phase hidden output includes a plurality of previous in-phase hidden elements, the previous quadrature hidden output includes a plurality of previous quadrature hidden elements, and wherein the intermediate output magnitude includes a plurality of intermediate output magnitude elements, and the output phase includes a plurality of output phase elements, and wherein the output magnitude includes a plurality of output magnitude elements, each computed by performing the DVR operation on respective intermediate output magnitude element.

FIG.1 ------- ----- PRIOR ART

FIG.2A

FIG.2B

EP 4 318 941 A1

FIG.3A

EP 4 318 941 A1

FIG.3B

FIG.4

FIG.5

FIG.6

FIG.7

FIG.8

EP 4 318 941 A1

FIG.9

FIG.10

FIG.11

FIG.12

FIG.13

Europäisches
Patentamt

European
Patent Office

Office européen
des brevets

# EUROPEAN SEARCH REPORT

Application Number

EP 22 18 8837

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ZHU ANDING: "Decomposed Vector Rotation-Based Behavioral Modeling for Digital Predistortion of RF Power Amplifiers", IEEE TRANSACTIONS ON MICROWAVE THEORY AND TECHNIQUES, IEEE, USA, vol. 63, no. 2, 2 February 2015 (2015-02-02), pages 737-744, XP011572353, ISSN: 0018-9480, DOI: 10.1109/TMTT.2014.2387853 [retrieved on 2015-02-03] * abstract; figure 1 * | 1-10 | INV. H03F1/32 H03F3/24 H03F1/34 |
| A | LI HONGMIN ET AL: "Vector Decomposed Long Short-Term Memory Model for Behavioral Modeling and Digital Predistortion for Wideband RF Power Amplifiers", IEEE ACCESS, IEEE, USA, vol. 8, 31 March 2020 (2020-03-31), pages 63780-63789, XP011783644, DOI: 10.1109/ACCESS.2020.2984682 [retrieved on 2020-04-14] * abstract; figures 1-4 * | 1-10 | |
| X | YU YUCHENG ET AL: "Behavioral Modeling of Millimeter Wave Beamforming Transmitters with Vector Decomposition Time Delay Recurrent Neural Network", 2020 INTERNATIONAL CONFERENCE ON MICROWAVE AND MILLIMETER WAVE TECHNOLOGY (ICMMT), IEEE, 20 September 2020 (2020-09-20), pages 1-3, XP033892087, DOI: 10.1109/ICMMT49418.2020.9386568 [retrieved on 2021-03-24] * abstract; figure 4 * | 1-10 | |

TECHNICAL FIELDS SEARCHED (IPC)

H03F

The present search report has been drawn up for all claims

| Place of search | Date of completion of the search | Examiner |
|---|---|---|
| The Hague | 10 January 2023 | Zakharian, Andre |

EPO FORM 1503 03.82 (P04C01)